(19) Europäisches Patentamt

European Patent Office

Office européen des brevets

(11) **EP 1 395 840 B1**

(12) **EUROPEAN PATENT SPECIFICATION**

(45) Date of publication and mention
of the grant of the patent:
**23.02.2005 Bulletin 2005/08**

(51) Int Cl.⁷: **G01R 31/11**

(86) International application number:
**PCT/GB2002/002694**

(21) Application number: **02735613.8**

(22) Date of filing: **12.06.2002**

(87) International publication number:
**WO 2002/101401 (19.12.2002 Gazette 2002/51)**

(54) **FAULT DETECTION SYSTEM AND METHOD**

FEHLERDETEKTIONSSYSTEM UND -VERFAHREN

SYSTEME ET PROCEDE DE DETECTION D'ANOMALIES

(84) Designated Contracting States:
**AT BE CH CY DE DK ES FI FR GB GR IE IT LI LU MC NL PT SE TR**

(30) Priority: **12.06.2001 GB 0114273**

(43) Date of publication of application:
**10.03.2004 Bulletin 2004/11**

(73) Proprietor: **Phoenix Aviation and Technology Limited**
**Oaklands, Welwyn, Hertfordshire AL6 0SS (GB)**

(72) Inventor: **LACEY, Glenn**
**Epsom, Surrey KT18 7LJ (GB)**

(74) Representative: **Ertl, Nicholas Justin et al**
**Elkington and Fife LLP,**
**Prospect House,**
**8 Pembroke Road**
**Sevenoaks, Kent TN13 1XR (GB)**

(56) References cited:
**US-A- 4 970 466          US-A- 5 461 318**

## Description

### Field of the Invention

The present invention generally relates to a method and system for fault detection and characterisation in metallic transmission cable using time domain reflectometry.

### Background to the Invention

Cables are relied upon to carry power and/or data between electrical and electronic apparatus throughout the world. Uses vary from linking computers in a network to devices within an aeroplane. Cables may be affected by their surrounding environment, wear and tear and other factors that reduce their power or data signal carrying capabilities. Whilst in some cases the drop in performance, accuracy or the loss of a power or data supply may not have severe repercussions, many uses are now termed as "mission critical", meaning that large sums of money, or in the most extreme cases lives, may be lost due to interruption of power and/or data.

It is therefore desirable and in some cases essential to check cables regularly.

One type of check for cables and signal paths is an impedance check. When a single pulse is launched into an electrical network, it may encounter various changes in cable impedance on its journey. These discontinuities in impedance have the effect of reflecting a certain amount of the signal back towards the source of the signal. By repeatedly launching a pulse or pulses onto a network and sampling the voltage at increasing points in time after initially launching the pulse, characteristics and discontinuities can be determined. A variety of electronic instruments exist for measuring electrical impedance between a pair of terminals. Impedance, expressed in units of ohms, defines the relationship of the electrical current I through the terminals to the voltage V across the terminals. In the simplest case, impedance may be purely resistive such that the voltage and current are in phase. The relationship is governed by Ohm's law such that R=V/I where R is the resistance. Impedance may also be complex when there is a significant amount of reactance between the terminals from capacitive or inductive elements.

One known technique for non-intrusively checking cables is Standing Wave Reflectometry (SWR). This is an impedance based technology in which the frequency of injected oscillating signals is varied in increments until a minimum, close to zero voltage is measured at a signal injection point. This is indicative of a minimum impedance at this point. The RMS voltage generated at the signal injection point in response to the applied test signal is monitored and analysed to determine the frequency to which the voltage is nearly zero volts. This indicates that the reflected signal from the discontinuity is approximately 180 degrees out of phase from the injected signal. This occurs when either an Open Circuit exists (at a distance of Quarter Wavelength of the injected signal down the cable) or a Short Circuit exists (at a distance approximately Half Wavelength down the cable).

Unfortunately, SWR is limited in performance by the fact that its diagnostics capabilities are restricted to only detecting Open and Short circuits on a "Single Channel". Furthermore, its distance measurement resolution is not very accurate and it has no Prognostic capability at all.

Pulse-based measurements of impedance may be performed by a time domain reflectometer (TDR) in a manner well known in the art. Time Domain Reflectometry (TDR) techniques have been available for at least the last 30 years and have been used in several application areas not least Test and Measurement both in relation to Copper based cables and the emerging Fibre Optic based cables, the latter techniques being known as Optical Time Domain Reflectometry (OTDR). The essence of TDR is to measure the time taken for a transmitted pulse and reflection to be sent down a cable and returned to its start point, the polarity characteristics of the reflection being further processed to determine a typical discontinuity such as an Open Circuit or Short Circuit. A TDR performs an impedance measurement by introducing an incident pulse of known magnitude into a transmission medium such as shielded and unshielded twisted pairs, coaxial cables, and the like, and measuring the resulting reflected signal. The pulse is introduced at a given pulse repetition rate, depending upon the designated range of the TDR. During the periods between pulses, acquisition circuitry samples the cable to acquire data representative of reflections from flaws, discontinuities, or breaks in the cable. The reflections in the cable are timed from the time of transmission of the energy pulse to determine the range from the transmitter to such flaws, discontinuities, or breaks. Reflections may represent changes in wire gauge, splices, moisture in the cable, and the like. The acquired data is normally processed and displayed as a waveform trace on a display device, such as a cathode-ray-tube, a liquid crystal display; or the like.

A TDR notes any changes in the characteristic impedance of the cable under test. For a telecommunications copper facility or plant, the characteristic impedance is typically between 100 and 125 Ohms. Most unshielded cables fall between 100 and 105 Ohms. Shielded cable like T1 is typically about 125 Ohms. Any change in the cable's impedance is displayed on the TDR display device as a positive waveform, negative waveform, or some combination of both deviating from a horizontal trace.

Because the incident pulse width can be made very narrow, typically less than ten nanoseconds, the TDR can measure impedance as a function of time. TDR's thus have the ability to troubleshoot transmission lines by detecting discontinuities that can disrupt signals and are most often applied in measuring the impedance along transmission lines. Measuring impedance at selected points along the transmission line has the advantage of allowing faults or discontinuities along the transmission line to be detected and localized, a feature particularly desirable for field service applications. If the propagation velocity of signals through the transmission line are known, the time delay between incident and reflected pulses may be used to determine the distance to the fault from the instrument along the transmission line.

In performing an impedance measurement with a TDR, the magnitude of the reflected pulse as a fraction of the incident pulse may be used to calculate the characteristic impedance at any given point along the transmission line as referenced to the output impedance of the TDR.

To date, the main industries of Aerospace, Telecommunications, Scientific Research, Manufacturing and Test and Measurement services have used a number of Handheld and/or Laboratory equipment to obtain the variety of test results necessary to diagnose or prognose faults.

Whilst reasonably successful, no known individual piece of equipment provides techniques and means whereby any given number of varying cable types (Twisted Pair, Coaxial, Fibre, Single Core) with varying and unmatched impedances to the actual test equipment can be tested together for a variety of discontinuities, either as an individual element of a group of cables or as a complete group of cables of a larger complete system known as a Harness.

In addition, no known equipment to-date addresses the real problem of an unknown or undefined Termination/ Ground-return path as is the case with many Aerospace and Automobile connections which use Single Core cables (in many cases no impedance known) which are further influenced by the metal structure surrounding them.

Lastly, no known equipment to date provides for the above whilst Power and Data are being applied to the cable under test.

Any system, which provides all this with, enhanced Diagnostic and Prognostic capability, in Real-Time, will save many man-hours and improves the operational safety of Cable and Connecting system.

US 4 970 466, US 5 381 348 and US 5 461 318 disclose time domain reflectometry systems for cable testing.

US 5 677 633 discloses a time domain reflectometer comprising a transmitter for generating a test signal, a multiplexer connected to the transmitter and to a test port, the test port having a plurality of outputs, each being connectable to one of a plurality of transmission media to be tested, the multiplexer being controllable to route signals from the transmitter to a selected output of the test port.

## Statement of Invention

According to the invention, there is provided a time domain reflectometer comprising a transmitter for generating a test signal, a multiplexer connected to the transmitter and to a test port, the test port having a plurality of outputs, each being connectable to one of a plurality of transmission media to be tested, the multiplexer being controllable to cause routing of signals from the transmitter to a selected output of the test port,

wherein means is provided to determine, select or confirm the return ground path for the selected output port, and in that the reflectometer further comprises means for analysing reflected signals received back from the transmission media to be tested and the return ground path thereby enabling impedance changes along the length of the transmission media to be determined and the respective distance to the impedance changes, for transmission media of known and unknown impedance.

The present invention relates to a cable test system, comprising of Hardware and Software techniques that allow for varying types of cable to be tested at one end for impedance variations and mismatches, either as an individual entity or group, for a variety of faults and conditions, the latter being termed as respectively Diagnostics and Prognostics. Further, this invention can perform this in Real-Time with Power and or Data also being applied to the cable under test.

The present invention allows the implementation of a Real-Time, non-intrusive, fully automated, variable Cable and impedance-based, multiplexed cable testing system that uses Time Domain Reflectometry techniques. The system can process more than one cable type, with varying characteristics, at any one time during which it confirms and processes both the characteristics of the cable type under test and any discontinuities encountered during its operational life due to the impedance variations defined and processed. Furthermore, the system provides an extensive range of Real-Time Diagnostic and Prognostic data together with accurate location and interpretation of any said data and or discontinuity including, but not limited to, the additional mapping of impedance variations along the length of the cable.

A specifically designed General User Interface (GUI) allows the user to select and control tests. In particular, the user can select the number of Pin and Cable connections, the types to be tested and testing order.

Before a full test for discontinuities is commenced, the system transmits a pulsedown each Pin/Cable connection, processing each returned reflection to firstly confirm the characteristics of the Pin/Cable against pre registered parameters and secondly to confirm and/or allocate a Termination/Ground path and test its condition. During this phase a Multiplexer automatically switches to each Pin/Cable connection in accordance with the GUI selection. Once this phase is completed the Multiplexer is again switched through the chosen GUI sequence, this time using the allocated Termination/Ground return for a full discontinuity test. A single or continuous pulse can be further selected using the GUI and transmitted to each Pin/Connector combination in Real-Time. Each returned reflection obtained from the transmitted pulse and or pulses, is captured and stored. When the stored data is processed further through a set of pre determined algorithms, the system extracts unique characteristics, such that it allows the system to determine both characteristics of the individual cable and any associated discontinuities, thus facilitating full interpretation of the any discontinuity. Furthermore, reflections are processed as a function of measured time such that the location of the cable characteristic and or discontinuity can be accurately determined.

A micro-controller is used to control all physical Hardware operational requirements of the cable testing system. A Software based GUI is used to send commands to the micro-controller and any associated Hardware logic including, but not limited to, the Mulitplexer itself. The GUI then provides facilities for the processing of the returned data and display of the results on a suitable display device.

The cable test system can be fully integrated into various systems or hardware formats. Relevant industry standards in which implementation could be achieved include ISA, PCI, PCMCIA, ASIC, FPGA. Proprietary standards or systems can equally accept the system in various formats including Handheld, PC and or Embedded.

Instead of electrical pulses, light produced by, for example, an led or laser may be used to form a test system for use in an optical network.

The invention also provides a time domain reflectometry method.

## Brief Description of the Drawings

Figure 1 is a block diagram of a time domain reflectometry system according to an embodiment of the present invention;
Figures 2 and 3 are screen shots of a test configuration for an aircraft retraction motor system;
Figures 4, 5 and 6 are screen shots of test results from test configured in Figures 2 and 3; and,
Figure 7 is a schematic diagram of a channel from a multiplexer used in the system of Figure 1.

## Detailed Description

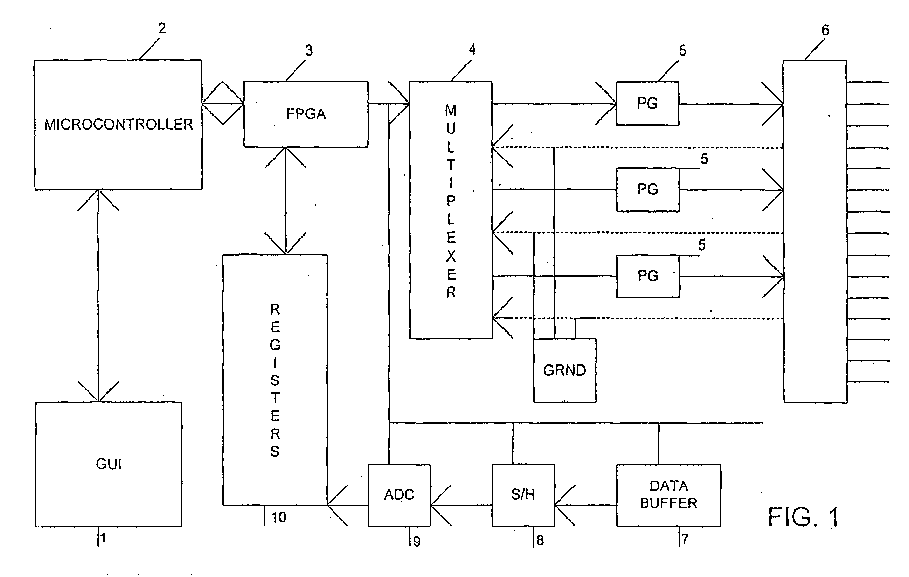

Figure 1 is a block diagram of a time domain reflectometry system according to an embodiment of the present invention. A graphic user interface (GUI) 1 is provided on a terminal, user input device, computer or the like for interacting with the system. Inputs via the GUI 1 are passed to a micro-controller 2. The microcontroller is in communication with a fixed programmable gate array (FPGA) 3 for controlling operation of the time domain reflectometry system. The FPGA 3 is connected to a multiplexer 4 for sending and receiving signals to and from one or more of a number of transmission mediums under test. Under control of the multiplexer 4, a transmitter, such as a variable pulse generator (PG) 5 produces interrogating energy pulses that are launched into its respective connected transmission medium to be tested via a test port 6. The transmission medium may be shielded or unshielded twisted pairs, coaxial cables, single core cabling or other types of metallic transmission mediums. Return signal energy from events in the cable under test representing flaws, discontinuities, or breaks in the cable is coupled to a data buffer 7 which is in turn coupled to a sampling circuit, such as a sample and hold circuit 8. The sampled analogue signal is coupled to an analogue-to-digital converter (ADC) 9 that converts the sampled analogue signal to digital values representative of the return signal from the cable under test. The digitised values are stored in a memory, such as a number of registers 10, for processing by the micro-controller 2 in the digital domain. The digital data representing the return signal energy from the cable under test is processed to detect the presence of events in the cable and generate characterization data on the detected events. The digitised waveform data along with acquisition parameter data and the characterization data of the detected events are output to the GUI 1.

The GUI 1 allows cable data to be entered into the system and for tests to be selected and initiated. A cable management section allows the user to add, delete and edit a data associated with a cable. Data stored in the cable management section is used automatically during the selection and execution of a test for that particular cable type. Data stored for a cable type includes:

| | |
|---|---|
| Description | Twisted Pair, RG58, Single Core etc. |
| Part Number | Manufacturer's Part Number |
| Impedance | Manufacturer's Specified Impedance (If any) |

(continued)

| Velocity Factor | Manufacturer's VF |
|---|---|
| Actual VF | Calculated |
| Loss | Manufacturer's dB Loss per/metre (If any) |
| Gauge | Gauge of Cable (If any) |

The cable management section also allows cabling systems, also known as a Harness in the aeronautic industry to be recorded. A cabling system incorporates a number of potentially different cables with different pin assignments when coupled to the test port 6. Data recorded for a cabling system includes:

| Description | description/name of system |
|---|---|
| MUX Channel | The Multiplexer Channel selected and allocated for the associated Pin / Circuit ready for testing. |
| Pin Number | Pin / Circuit Number |
| Return Pin (Gnd) | The physically allocated Termination / ground path for the Pin Circuit named (as in the case for Twisted Pair with a known Ground) or the automatically allocated Termination / Ground path for the Pin / Circuit named as in the case of Single Core. |
| Length (m) | Actual length of the Cable determined by the system when tested. |
| Cable Type | Type of pre registered Cable used on this Pin / Circuit. |

In operation, a user initiates a test via the GUI 1 causing a start command to be passed to the micro-controller 2. The micro-controller sends a command to the FPGA 3 whereby each channel in the multiplexer 4 is switched to and a pulse, typically of 30ns, is generated by the respective PG 5 and is injected into the connected cable/connector pin via a test port 6. Any reflected analogue pulse for that cable/connector pin is then received back via a predetermined channel and fed into the data buffer 7 then to the sample and hold circuit 8 then to the ADC converter 9 where it is converted and stored in the data register 10. The FPGA 3 then switches to this register thereby allowing the micro-controller 2 and the GUI 1 to extract the data for processing.

Preferably, the system determines the "start" impedance of a cable to be tested by using a predetermined algorithm. This process is repeated for every channel connected to the Multiplexer 4. The purpose of this is for the system to establish and confirm the impedance of cables under test both where impedance is known and where one is not known. The GUI 1 sends a command to the micro-controller 2 to start an initialising phase whereby the test port 6 is checked for discontinuities and authenticity. When this command is received, the micro-controller 2 sends an appropriate command to the FPGA 3 which initialises the Mutliplexer 4 by putting the start Channel and Pin numbers into the relevant registers. A small Pulse, typically 10ns, is then injected into the test port 6 as determined by the MUX Channel Registers. Because this initial Pulse is small it will be able to determine faults and discontinuities over the short distance of 1mm - 1m, thereby facilitating that the physical connection between the test unit and Cable/Harness under test is working. This sequence is repeated for all channels of the test port 6. If any faults are found the user is given an appropriate message via the GUI 1 and the test is halted. Preferably, the test port 6 is in the form of an interface cable. The cable may have an embedded logic device that can be queried for authenticity of the cable and/or determination of parameter values for the cable before a test is finally initiated. The data recorded in the logic device may include: the Part Number of the Cable (to check that the proper User Interface Cable is being used); User Registration Number (to authenticate the user of the system); and individual cable parameters such as Gauge, Product Number, etc (to verify that the Harness/cable under test has not been changed or rewired from previous test results). Any faults or invalid data will be displayed to the user via the GUI with an appropriate message.

The GUI 1 then sends a command to the micro-controller 2 to start a Termination/Ground test. The purpose of this test is to confirm the Termination/Ground return path for each Pin/cable selected for test. In most cases a connector will have a designated Ground Pin. Cable types such as Twisted Pair and Coaxial will also have a return path. However, in the case of Single Core cables, no impedance or return path is known and one must be determined in order to carry out testing. As the impedance of the cable was identified and confirmed in the steps above, the multiplexer 4 chooses the first Pin/Cable, looks at its stored impedance and then scans the results of the remaining Pin / Cables until it finds the closest matched impedance. These combination results are then stored for use in the main test sequence providing the multiplexer with the combination such that a ground rail 11 can be switched to the designated combination before the test, thereby providing a stable Termination and Ground return path. Using this method, the system is able to verify any predefined Termination/Ground return paths for existence and performance prior to testing.

Once these steps are completed, the micro-controller 2 processes the test configuration set up by the user in the GUI 1. It uses this to send the appropriate commands to the FPGA 3, which controls the flow of signals and data between the micro-controller 2 and multiplexer 4. The first thing the FPGA 4 does is to select another pulse width and type, typically 30ns, which gives a longer range whilst still maintaining accurate resolution typically 1mm/1cm. The channel and pin numbers for the cable to be tested are put in the relevant registers, this having been determined by the user and GUI 1. The Termination/Ground return path pin is also selected and put into another appropriate register. The Mulitplexer 4 reads this and switches the Termination/Ground rail to the pre-allocated Pin. The test is then carried out on the Cable selected. The user can select via the GUI 1 a single pulse to be transmitted, whereby one pulse is transmitted with one Refection being processed for discontinuities, or a continuous pulse, whereby regular pulses are transmitted providing multiple reflections to be processed. Any faults and or discontinuities found are displayed via the GUI 1 in a suitable fashion.

The system allows for multiple cable types of known and unknown impedance to be processed. To facilitate this, the system circuitry has to have a fixed Resistance path. It has been determined that approximately 100 Ohms is best suited to the system although other resistances could be used without substantially affecting operation of the system. It has been found that a range of 75-130 Ohms would work in this case. This resistance was found to give a dynamic range/loss coefficient when testing a range of cables with varying impedances between 25 Ohms - 400 Ohms. This means that reflection being received back is sufficient and constant in width and amplitude in order for the system to provide diagnostic and prognostic capabilities.

The described system is able to identify and analyse small and large changes of impedance to within a pre programmed user resolution along the length of the cable under test. This leads to the ability for a wide range of faults being detected and analysed and monitored. Some of the diagnostic and prognostic capabilities of the system include:

| Signal | Meaning |
| --- | --- |
| No return reflection | Cable correctly terminated, no faults |
| Positive full range reflection | Open Circuit |
| Negative full range reflection | Short Circuit |
| Positive/Negative combination full range at specific location | Splice and/or Junction |
| Positive Variable Range at specific area | Exposed Conductor |
| Positive Constant Range at specific area | Dielectric Damage |
| Positive Constant Range at variable area | Water Ingression |
| Positive/Negative zero crossing at variable range | Applied Pressure |
| Positive Variable Range at specific location | Corrosion/resistance |

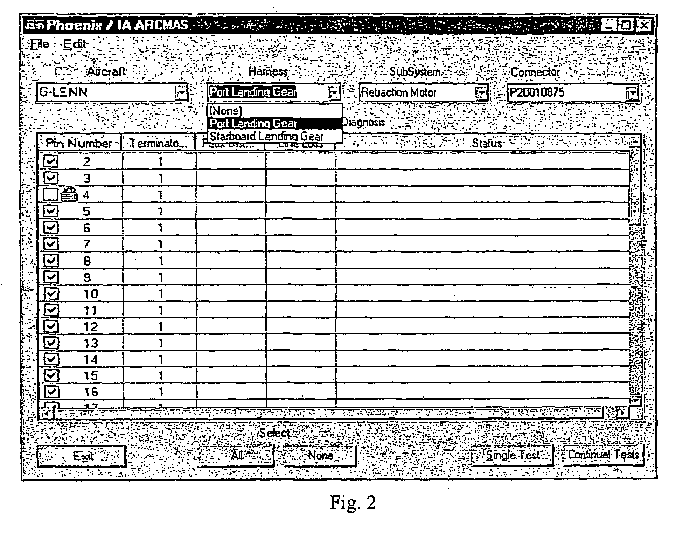

Figure 2 is a screen shot of a test configuration for an aircraft retraction motor system. This screen shows that the Retraction Motor system for the Port landing Gear is being fully tested, when the test was initiated the system Locks out Pin Number (4) and does not test it. This is due to insufficient information being recorded to allow a proper test of the Pin / Circuit.

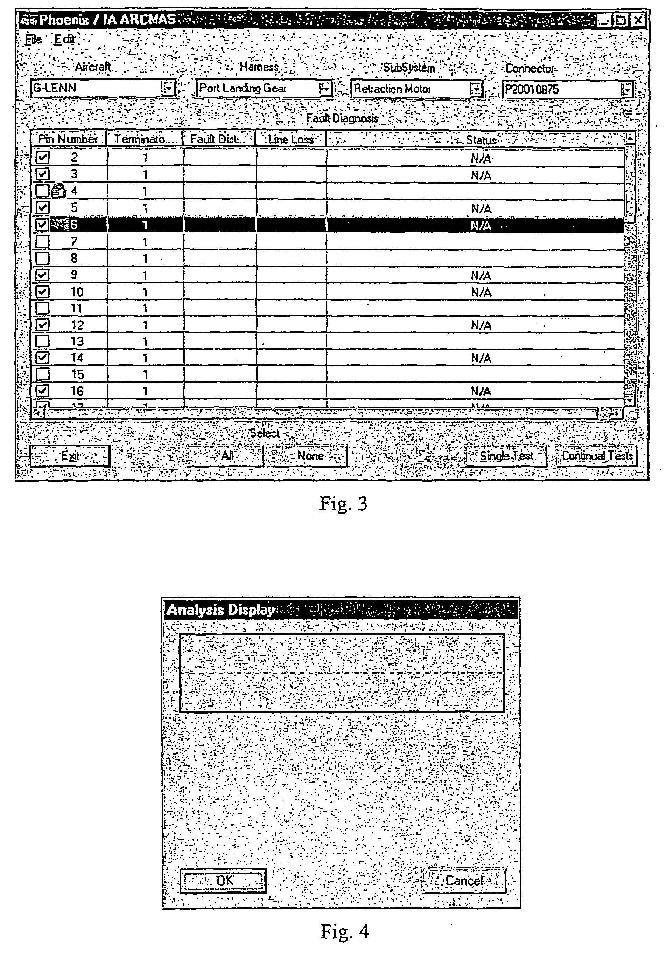

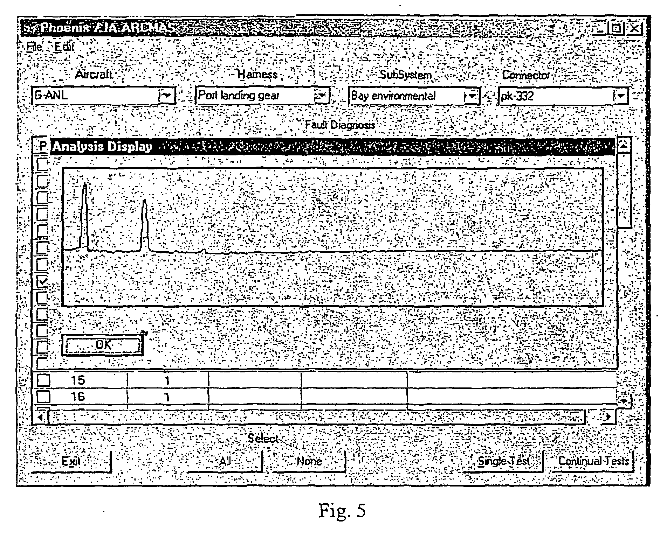

Figures 3, 4, 5 and 6 are screen shots of test results from test configured in Figure 2. Figure 3 shows that a continuous pulse test has been applied. No faults have been found and Pin / Circuit number 4 was Locked out of the test. In addition Pin / Circuit number 6 was selected by the user (during continuous Real-Time Testing) for a "Trace" selection being confirmed by the background highlight. This means that at any time during a test the user can look at a scaled down version of the Pulse Signal and trace of the fault. Figure 4 shows the output when no pulse is active in the Cable selected and Figure 5 shows the pulse and its reflections depicting that a fault has been located. In this case the fault is an Open Circuit.

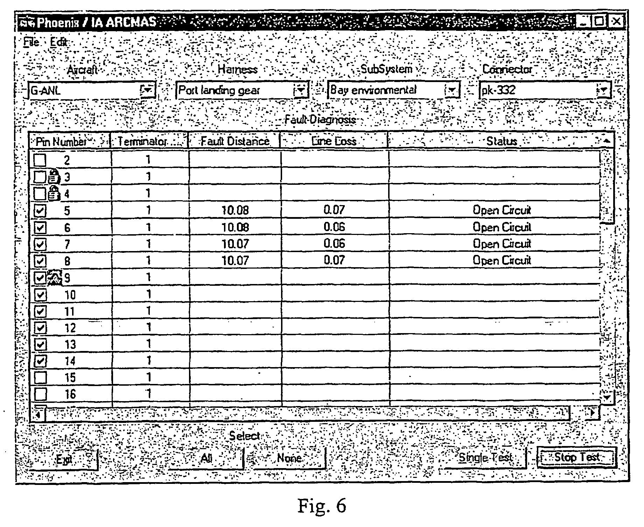

Figure 6 shows selected Pins/Circuits of the Environmental Bay within the Port Landing Gear being tested. Faults found are displayed under the status field together with the Line Loss and distance to the fault. The system also shows two locked out Pin/Circuits (numbers 3 and 4) and shows pin 9 as the current Pin/Circuit under test.

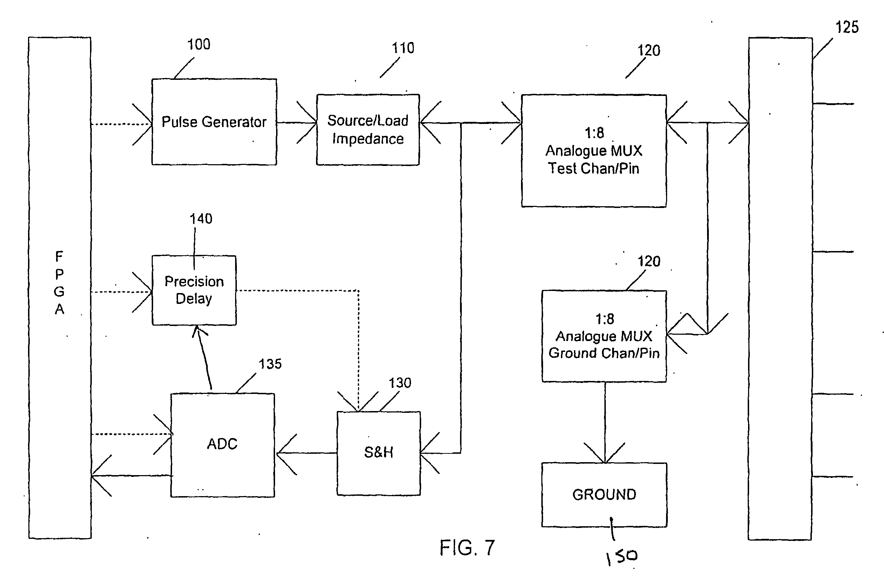

Figure 7 is a schematic block diagram of a channel of the multiplexer described with reference to Figure 1. The complete multiplexer may have any number of channels, each channel having a corresponding architecture to that in described with reference to Figure 7. In a preferred configuration, the multiplexer has six channels.

Each channel has a bi-directional, single pole, multi-throw relay configuration and allows a bi-directional flow of data and power down a single pre-selectable path. The multiplexer is controllable to switch a channel's path for selection of both the cable to be tested and the associated ground path for the path under test.

Each channel includes a pulse generator 100 connected to a load impedance module 110 which in turn feeds an 8-way multiplexing module 120 that is connected to a test port 125. On the return signal path, the 8-way multiplexer 120 feeds a sampling unit 130 that is connected to an analogue to digital converter (ADC) 135. The ADC is connected to a number of delay offset registers 140 that are described in more detail below. The components within the channel are controllable by the FPGA described with reference to Figure 1. Dashed lines represent control inputs whilst solid lines represent data flow.

In order to achieve a reasonable analogue/RF performance, the pulse generator and sampling unit have to have exact performance and position on the PCB board with respect to the number of channels. In one example, one pulse generator and sampling unit is used per channel. Alternatively, one pulse generator may be used for all channels.

In an example, the performance and characteristics of the multiplexer is selected as:

| Property | Value | Unit | Tolerance | Comment |
|---|---|---|---|---|
| Input Impedance | 100 | Ohms | +/- 10% | |
| Output Impedance | 100 | Ohms | +/- 10% | |
| Forward Loss | 1 | dB | | = or < than |
| Reverse Loss | 1 | dB | | = or < than |
| Supply Voltage | 12 | Volts | +/- 10% | |
| Supply Current | 250 | mA | | |
| Isolation | 40 | dB | | > or = to |
| Switching Speed | 5 | Microsecond | | < or = to |
| Bandwidth | 3 | GHz | | |

Each channel of the multiplexer can be operated in the manner similar discussed above in Figure 1. Each channel is only responsible for cables/contacts the 8 pins of the multiplexer can be connected to. For example if a cable of 20 wires is connected to the test port - wire 1 to pin 1 etc, to test pin 7, channel 1 must be used and to test pin 17, channel 3. A ground node 150 is a connection common to all channels. Any channel can assign a pin to the ground node 150 via suitable routing in its multiplexer. The ground node is then used during a test as the return path. Selection of the most appropriate return path/termination pin has been discussed above with reference to Figure 1. Any of the 8 pins of a channel can be routed to the sampling unit, to the ground node or left as an open circuit. Typically during a test, the cable to be tested is routed to a sampling unit, the cable selected as the return path is routed to the ground node and all other cables are left as open circuits.

A value of 100 Ohms is used for the impedance of the multiplexer circuit together with the matching interconnect circuitry. Although other values may be used, it has been found that this value provides superior performance with values of impedance encountered in cabling. Typical cabling values range from 25 to 400 Ohms. Utilising the potential divider concept where voltage at a point is the source voltage $V_s$, the source Impedance is $Z_S$, and the Load impedance is $Z_L$, the equation for the amount of transmitted energy or voltage at the line is:

$$Z_L / (Z_L + Z_S)$$

Therefore, in the case when $Z_L$ is equal to $Z_S$ 50% of the source voltage of the reflection will be divided in a similar manner according to $Z_S / (Z_L + Z_S)$ and in the case of $Z_L$ equal to $Z_S$, 50% of the reflected pulse is "Received" at the input circuit.

These two ratios are then multiplied to obtain the overall efficiency (the dynamic range of the signal returned) of the multiplexer channel circuitry in terms of voltage transmission and reflection and the degree of variation experienced with various load impedances.

In the case of $Z_L = Z_S$ taking 50% (0.5) and multiplying by the received efficiency results in 0.5 x 0.5 = 0.25 or 25% efficiency for the ideal case of $Z_L = Z_S$

In another example, taking an expected extreme of 25 Ohms, a transmit efficiency of 25/ (100+25) = 0.2 (20%) and a receive efficiency of 100 / (100+25) = 0.8 (80%) is obtained. Multiplying both transmit and receive efficiencies gives an overall transfer efficiency of 0.2 x 0.8 = 0.16 (16%).

Taking an extreme of 400 Ohms for the load impedance, a transmit efficiency of 400 / (400+100) = 0.8 (80%) and a receive efficiency of 100 / (400+100) = 0.2 (20%) is obtained. Once again, multiplying transmit and receive efficiencies gives a transfer efficiency of 0.8 x 0.2 = 0.16 (16%).

It can thus be seen that the selection of 100 Ohms impedance allows a wide range of load impedances to be tested without dramatically affecting transfer efficiency.

The following sections describe algorithms and techniques used in the present invention:

*Calculating "Start" or "Actual" Impedance*

$$Z = (R * V_o) / (V_g - V_o)$$

Where:

Z    is the cable impedance
R    is the series-driving resistor
$V_g$    is the height (in Volts) of the raw pulse generated before the resistor
$V_o$    is the height (in Volts) of the outgoing pulse as captured at source

By locating the time at which a reflected pulse reappears at the source, a profile can be built of the discontinuities that the signal has encountered as it propagates along the cable.

To transform the measured impedance from the time domain into distance, the following equation is used:

$$d = cvt$$

Where:

d    distance (Programmable value, e.g. 1mm or 1foot 1Km etc)
c    Speed of light in a vacuum (2.00 x 10(s) ms $^{-1}$)
v    Velocity factor of the conductor
t    Time taken for the reflected pulse to return to source

The velocity factor (VF) number of a cable is determined by the dielectric material that separates two conductors. In coaxial cables, it is the foam separating the centre conductor and the outer sheath is the material determining the VF (The speed of light in a vacuum is 186,400 miles per second, this speed is represented by the number 1 all other signals are slower so a cable with a VF of .85 would transmit a signal at 85% the speed of light). In twisted pair cables, it is the plastic that separates the cables that is the determining factor. Most cables come with a manufacturers VF, however, this factor is influenced by other factors such as an example aircraft structure so an error percentage needs to be addressed. Furthermore, Single core wire does not have a VF due to the fact that it does not meet the "material between two conductors" criteria.

To address these problems, to determine the VF for a cable several differing levels of return reflections are taken at differing sample lengths along the cable these are then averaged as a function of time thus allowing to check between the actual and stated VF. Additionally, a Ground return path is established (as described above with reference to Figure 1) and the same process is repeated. It is accepted practice that in order to establish the VF accurately one must generate reflections from Open and Short circuits and not Correctly Terminated Cable. However, in the system according to the present invention the latter is not true because it has such a high resolution and overall dynamic range even small reflections generated by Correct Terminations can be used in the determination and verification of the VF.

A set of time delay offset registers is used to increase sampling and therefore resolution. During testing, a signal pulse is transmitted along the cable to be tested. The cable is monitored for signal reflections indicative of faults. Normal sampling is performed every 250ns giving a resolution of 3 or 4 cm. However, when a signal reflection above a predetermined threshold is detected, the time taken from transmission to receipt of the reflection is recorded and a further pulse is transmitted. When the recorded time less a predetermined amount has expired, the delay offset register is triggered.. The delay offset register samples for signals on the cable at a higher quantisation than previous sampling and therefore can identify the time of the reflection (and therefore its location along the cable) with a higher degree of resolution. Depending on the system configuration, this step may also be repeated a number of times using further delay offset registers that each increase sampling rate and therefore resolution, each narrowing the range in the cable in which the fault is likely to have occurred.

In an example, 3 delay offset registers are used: Coarse, Fine and Ultrafine. Using a 50 Ohm Coaxial Cable with a Velocity Factor of 75% the following results are obtained:

| Delay offset type | Quantisation | Approx Resolution |
|---|---|---|
| Coarse | 250ns | 28 metres |
| Fine | 0.977ns | 11cm |
| Ultrafine | 9.77ps | 1.1mm |

*Determining Type of Discontinuity*

The exact amount of signal reflected back to the source is called the reflection coefficient and depends on the characteristic impedance of the conductor and the impedance at the discontinuity.
The reflection coefficient is defined as:

$$T = (Z_L - Z_0) / (Z_L + Z_0)$$

Where:

T =     Reflection Coefficient
$Z_L$ =     Discontinuity Impedance
$Z_0$ =     Characteristic Impedance

Some common relationships are:

| $Z_L = Z_0$ | T=0 | Correctly Terminated |
|---|---|---|
| $Z_L = \infty$ | T = +1 | Open Circuit |
| $Z_L = 0$ | T=-1 | Short Circuit |
| $Z_L > Z_0$ | 0<T<+1 | Partially Open |
| $Z_L < Z_0$ | -1 < T < 0 | Partially Short |

This is performed automatically by the system as a function of reflection width, amplitude, distance and time.

*Reference Trace*

Prior to performing any analysis a reference trace is taken by scanning across the whole distance of the cable correctly terminated. By subtracting the reference trace from subsequent scans, any DC offsets and or predictable noise can be eliminated prior to subsequent processing.
This is particularly useful in a Power environment where the cable is not correctly terminated. In this instant impedance mismatches occur throughout the length of the cable due to the presence of devices such as motors, relays, switches, lamps etc, but are accepted as being part of the working environment. By scanning the cable in a known faultless state and subtracting this trace from subsequent traces, this allows further processing stages to concentrate on detecting only new faults.

*Hysteresis*

Having captured a reference trace, the cable is scanned using the previously mentioned course, fine and ultra fine delay registers.
A hysteresis algorithm is used to determine the approximate location of the reflected pulses. A number of thresholds are set to determine which is an actual pulse worth investigating as opposed to Noise etc. The thresholds may be adjusted to take into account characteristics of the cable/device being tested. At this stage the Peak magnitude and Polarity of the Pulses is determined, and stored for use in later algorithms.

*Centre of Mass*

Whilst peak detection using hysteresis would produce acceptable results, losses in the cable have the effect of spreading the concentration of pulse energy away from the centre of the pulse, thus reducing the sharpness of the edges of the reflected pulse.

After determining the locations of the pulses using hysteresis the centre of mass (or 1st moment) of the area about the suspected pulse is calculated to determine a more precise location of an impedance mismatch and or impedance change. The addition of this algorithm gives us a more accurate position measurement as it takes into account the spread of the signal and focuses in on the location containing maximum energy.

$$COM = \sum_{i=0,N} Y_{(t+i)} \, i \, / \, / \sum_{i=0,N} Y_{(t+i)}$$

Where:

Y = Trace value amplitude
t = Sample number about pulse leading edge
N = Samples to pulse trailing edge

*Cross Correlation Function*

To add further accuracy in determining the location of the pulse especially in a noisy Environment, namely to establish an exact location, a cross-correlation algorithm is used. Cross Correlation provides us with a measure as to the degree of similarity between two signals. For two given sets of date, x and y the cross correlation is defined as:

$$r_{xy} = (1/N) \sum_{i=0,N-1} x\,(i)\, y\,(i)$$

This equation gives us a single measure as to the similarity of the two signals. A positive sum indicates a positive degree of correlation. If the two signals are completely uncorrelated, the results are close to zero.

In order to use this equation more effectively to determine the location of the pulse we need to introduce a phase shift to one of the signals, as the following equation depicts:

$$r_{xy}(j) = (1/N) \sum_{i=0,N-1} x\,(i)\, y\,(I+j) \quad j=0,N-1$$

By introducing the phase shift we obtain a set of data points $r_{xy}(j)$ which we can scan to find the shift corresponding to the maximum level of correlation.

Cross Correlation can be quite computationally inefficient so we can improve efficiency by electing to use an FFT algorithm:

$$r_{xy}(j) = (1/N)F^{-1}\{X(-k)Y(k)\}$$

Where:

$F^{-1}$ = Inverse FFT
X(-k) = FFT(-k)
Y(k) = FFT(k)

The FFT equation is functionally identical in result to the original equation but requires only $(N/2)\log_2 N$ oper-

ations per FFT. The complexity is further reduced by pre-calculating the reference function X(-k), thus resulting in a computational complexity of Nlog$_2$N operations. This reduces the complexity of calculating the sequence by a factor of a thousand.

The apparatus of the invention has been described above for use in detecting various conditions in transmission media, such as open and short circuits, as well as junctions and other conditions.

However, as a result of the various platforms that the system design can be applied to, the system lends itself to being integrated into a Circuit Breaker format whereby pre-arcing conditions and pre-arcing location can be identified in a Conductor / Circuit before a full blown arcing event occurs. Pulses are sent out continuously either at predefined timed intervals and/or event driven. When an arc starts to develop either by the conductor rubbing against a metal structure or by two conductors against each other, the system detects "Short Circuit" reflections as a function of time. With a pre-arc event there will either be a succession of rapid short circuits or periodical short circuits, which are continuously logged and processed by the system. If many short circuits occur in the same location the system identifies this as a pre-arc event.

The system also has the ability to monitor the reactivity of various Heat Sensitive Cable Sensors such as Linear Heat Detector, Firewire, Thermocoax either as an individual sensor or group of sensors. When the sensor reacts such that the impedance of that sensor changes, the system detects this, locates it and monitors it. In the case of a fire, the system is thus able to give direction and speed of fire and or temperature change in Real-Time. It also has the ability when used with a Thermocoax type sensor to detect and record such small changes of impedance within the sensor that a direct relationship can be established in table format of how many Ohms per rate of Degrees Celcius change. With this data the system can produce a 3 Dimensional Thermograph map on any suitable display device.

The system generates and uses variable pulses and as such processes the return reflections. In the case of multiple branches, any pulse that is generated will be transmitted and reflected back in all junctions therefore making it difficult in such installations to identify which side the fault is located. In this system, two functions provide key information in determining which side the fault has been located in. Firstly, the length of each individual branch together with the timed generation and processing of variable pre-allocated pulses is possible. For example, a pulse width of 30ns can be used for all Right Hand branching and a pulse width say of 20ns for all Left Hand branching. Whilst all pulses will be generated and reflected down all sides, by predetermining which pulse widths are associated with which sides of the installation and processing the reflections accordingly provides a means of determining which side.

The system of the invention provides the ability, using a static pre-defined impedance, to process varying cable types and varying cable impedances within the same unit, and to locate, interpret and identify various faults in these cables. The system enables a "single core" wire with no known impedance to be identified and the impedance to be calculated. This "single core" wire can have no known return path, and the system can, from the calculated impedance, work out and assign the best-known return path. Automatic allocation of the correct circuit path for the wire can then be carried out with to enable for faults.

The apparatus can be used with AC/DC power or data being transmitted in the cable.

The apparatus can be used to provide a detailed Impedance map of an Individual Cable or Harness or Installation. Automatic testing of the impedance of Interconnect Circuits and Interconnections for damage can be carried out before cable testing starts, and all Ground / Return paths can also be tested for faults and performance degradation.

The apparatus can be applied to various Hardware Platforms and various Software Operating Platforms. Authenticity and damage of actual Interface Cables can be tested.

**Claims**

1.  A time domain reflectometer comprising a transmitter for generating a test signal, a multiplexer (4) connected to the transmitter (5) and to a test port (6), the test port (6) having a plurality of outputs, each being connectable to one of a plurality of transmission media to be tested, the multiplexer (4) being controllable to cause routing of signals from the transmitter to a selected output of the test port (6),
    **characterised in that** means (2) is provided to determine, select or confirm the return ground path for the selected output port, and **in that** the reflectometer further comprises means for analysing reflected signals received back from the transmission media to be tested and the return ground path thereby enabling impedance changes along the length of the transmission media to be determined and the respective distance to the impedance changes, for transmission media of known and unknown impedance.

2.  A time domain reflectometer as claimed in claim 1, wherein the circuitry (4, 5, 6) has a fixed impedance for all media to be tested.

3.  A time domain reflectometer as claimed in claim 2, wherein the fixed impedance is an output impedance of 75 -130 Ohms.

4. A time domain reflectometer as claimed in claim 3, wherein the fixed output impedance is approximately 100 Ohms.

5. A time domain reflectometer as claimed in any preceding claim, wherein the means for analysing reflected signals enables the impedance to be determined of transmission media connected to each test port (6) output.

6. A time domain reflectometer as claimed in claim 5, further comprising means for determining, for a transmission medium to be tested, the transmission medium connected to another test port having the closest matched impedance for use as a ground return path.

7. A time domain reflectometer as claimed in any preceding claim, further comprising a plurality of time delay offset registers (140) controlled by thresholds which in turn generate different sampling rates, each sampling rate providing a different distance resolution.

8. A time domain reflectometer as claimed in claim 7, wherein the means for analysing reflected signals sets a number of thresholds which trigger the time delay offset registers (10).

9. A time domain reflectometer as claimed in any preceding claim, wherein the means for analysing includes an algorithm for initially determining the location of the reflected pulse or pulses and for confirming that the pulse or pulses represent a fault in the transmission media.

10. A time domain reflectometer as claimed in any preceding claim, wherein the means for analysing includes a centre of mass algorithm for determining more accurately the level of impedance change.

11. A time domain reflectometer as claimed in any preceding claim, wherein the means for analysing includes a cross correlation algorithm for more accurately determining the location of a pulse or pulses.

12. A time domain reflectometer as claimed in any preceding claim designed as a fully integrated ASIC.

13. A time domain reflectometer as claimed in any preceding claim which can be used with a transmission medium that also has AC or DC power or data being transmitted in the transmission medium at the same time as the test is being conducted.

14. A time domain reflectometer as claimed in any preceding claim, further comprising means for providing an impedance map of an individual cable or harness of installation under test.

15. A time domain reflectometer as claimed in any preceding claim, further comprising a receiving circuit connected to the multiplexer (4), the multiplexer being controllable to route reflected signals from the selected output to the receiving circuit, wherein the receiving circuit is connected to a sample and hold circuit (8, 130) for sampling received signals.

16. A time domain reflectometer as claimed in claim 15, further comprising a controller (2) arranged to control the multiplexer (4) to determine and establish signal routing paths from the transmitter (5) to the selected output, wherein the controller is arranged to accept an input selecting the output to be tested, to control the multiplexer to establish a signal routing path from the transmitter to the selected output, determine and establish a signal routing return path from the selected output to the receiving circuit.

17. A time domain reflectometer as claimed in claim 16, further comprising a ground node (GRND) connected to the multiplexer, wherein the multiplexer (4) is controllable to route signals from the transmission media to the ground node.

18. A time domain reflectometer as claimed in claim 17, wherein the controller is arranged to switch between each output to determine closest impedance to the selected output and to establish the return path and hence the signal routing path between the output, return path and ground node.

19. A method of performing time domain reflectometry, comprising:

generating a test signal at a transmitter (5),
supplying the test signal under the control of a multiplexer (4) to a test port (6);
connecting each of a plurality of test port (6) outputs to one of a plurality of transmission media to be tested;

**characterised in that** the method comprises:

determining, selecting or confirming the return ground path for the selected output port; and
analysing reflected signals received back from the transmission media to be tested and the return ground path
thereby enabling impedance changes along the length of the transmission media to be determined and the
respective distance to the impedance changes, for transmission media of known and unknown impedance.

**Patentansprüche**

1. Ein Zeitbereichsreflektometer, das einen Sender zum Erzeugen eines Testsignals, einen mit dem Sender (5) und mit einem Testtor (6) verbundenen Multiplexer (4) aufweist, wobei das Testtor (6) eine Mehrzahl von Ausgängen aufweist, von denen jeder mit einem einer Mehrzahl von zu testenden Übertragungsmedien verbindbar ist, wobei der Multiplexer (4) steuerbar ist, um eine Weiterleitung von Signalen von dem Sender an einen ausgewählten Ausgang des Testtors (6) zu bewirken,
**dadurch gekennzeichnet, dass** eine Einrichtung (2) vorgesehen ist, um den Erdrückpfad für das ausgewählte Ausgangstor zu bestimmen, auszuwählen oder zu bestätigen, und dadurch, dass das Reflektometer ferner eine Einrichtung zum Analysieren reflektierter Signale aufweist, die von dem zu testenden Übertragungsmedium und dem Erdrückpfad zurückempfangen werden, wodurch ermöglicht wird, dass Impedanzänderungen entlang der Länge der Übertragungsmedien und die jeweilige Entfernung zu den Impedanzänderungen für Übertragungsmedien mit bekannter und unbekannter Impedanz bestimmt werden.

2. Ein Zeitbereichsreflektometer gemäß Anspruch 1, bei dem die Schaltungsanordnung (4, 5, 6) für alle zu testenden Medien eine festgelegte Impedanz aufweist.

3. Ein Zeitbereichsreflektometer gemäß Anspruch 2, bei dem die festgelegte Impedanz eine Ausgangsimpedanz von 75 bis 130 Ohm ist.

4. Ein Zeitbereichsreflektometer gemäß Anspruch 3, bei dem die festgelegte Ausgangsimpedanz etwa 100 Ohm beträgt.

5. Ein Zeitbereichsreflektometer gemäß einem der vorhergehenden Ansprüche, bei dem die Einrichtung zum Analysieren reflektierter Signale ermöglicht, dass die Impedanz von Übertragungsmedien, die mit jedem Ausgang des Testtors (6) verbunden sind, bestimmt wird.

6. Ein Zeitbereichsreflektometer gemäß Anspruch 5, das ferner eine Einrichtung zum Bestimmen, für ein zu testendes Übertragungsmedium, des Übertragungsmediums, das mit einem anderen Testtor verbunden ist, das die am nächstliegenden abgestimmte Impedanz zur Verwendung als Erdrückpfad aufweist.

7. Ein Zeitbereichsreflektometer gemäß einem der vorhergehenden Ansprüche, das ferner eine Mehrzahl von Zeitverzögerungsversatzregistern (140) aufweist, die durch Schwellen gesteuert werden, die wiederum verschiedene Abtastraten erzeugen, wobei jede Abtastrate eine andere Entfernungsauflösung liefert.

8. Ein Zeitbereichsreflektometer gemäß Anspruch 7, bei dem die Einrichtung zum Analysieren reflektierter Signale eine Anzahl von Schwellen einstellt, die die Zeitverzögerungsversatzregister (10) auslösen.

9. Ein Zeitbereichsreflektometer gemäß einem der vorhergehenden Ansprüche, bei dem die Einrichtung zum Analysieren einen Algorithmus zum anfänglichen Bestimmen der Position des reflektierten Pulses oder der reflektierten Pulse und zum Bestätigen, dass der Puls oder die Pulse einen Fehler in dem Übertragungsmedium darstellt beziehungsweise darstellen, umfasst.

10. Ein Zeitbereichsreflektometer gemäß einem der vorhergehenden Ansprüche, bei dem die Einrichtung zum Analysieren einen Schwerpunktalgorithmus zum präziseren Bestimmen des Pegels der Impedanzänderung umfasst.

**11.** Ein Zeitbereichsreflektometer gemäß einem der vorhergehenden Ansprüche, bei dem die Einrichtung zum Analysieren einen Querkorrelationsalgorithmus zum präziseren Bestimmen der Position eines Pulses oder von Pulsen umfasst.

**12.** Ein Zeitbereichsreflektometer gemäß einem der vorhergehenden Ansprüche, das als vollständig integrierte ASIC entworfen ist.

**13.** Ein Zeitbereichsreflektometer gemäß einem der vorhergehenden Ansprüche, das bei einem Übertragungsmedium verwendet werden kann, das ferner eine Wechselstromoder Gleichstromleistung oder Daten aufweist, die zur selben Zeit, wie der Test durchgeführt wird, in dem Übertragungsmedium übertragen werden.

**14.** Ein Zeitbereichsreflektometer gemäß einem der vorhergehenden Ansprüche, das ferner eine Einrichtung zum Bereitstellen einer Impedanzabbildung eines zu testenden einzelnen Installationskabels oder eines zu testenden Installationskabelsatzes aufweist.

**15.** Ein Zeitbereichsreflektometer gemäß einem der vorhergehenden Ansprüche, das ferner eine mit dem Multiplexer (4) verbundene Empfangsschaltung aufweist, wobei der Multiplexer steuerbar ist, um reflektierte Signale von dem ausgewählten Ausgang an die Empfangsschaltung weiterzuleiten, wobei die Empfangsschaltung mit einer Abtasten-und-Halten-Schaltung (8, 130) zum Abtasten empfangener Signale verbunden ist.

**16.** Ein Zeitbereichsreflektometer gemäß Anspruch 15, das ferner eine Steuerung (2) aufweist, die angeordnet ist, um den Multiplexer (4) zu steuern, um Signalweiterleitungspfade von dem Sender (5) zu dem ausgewählten Ausgang zu bestimmen und einzurichten, wobei die Steuerung angeordnet ist, um einen Eingang, der den zu testenden Ausgang auswählt, anzunehmen, den Multiplexer zu steuern, einen Signalweiterleitungspfad von dem Sender zu dem ausgewählten Ausgang einzurichten, einen Signalweiterleitungsrückpfad von dem ausgewählten Ausgang zu der Empfangsschaltung zu bestimmen und einzurichten.

**17.** Ein Zeitbereichsreflektometer gemäß Anspruch 16, das ferner einen mit dem Multiplexer verbundenen Masseknoten (GRND) aufweist, wobei der Multiplexer (4) steuerbar ist, um Signale von den Übertragungsmedien an den Masseknoten weiterzuleiten.

**18.** Ein Zeitbereichsreflektometer gemäß Anspruch 17, bei dem die Steuerung angeordnet ist, um zwischen jedem Ausgang zu schalten, um die dem ausgewählten Ausgang nächstliegende Impedanz zu bestimmen und um den Rückpfad und somit den Signalweiterleitungspfad zwischen dem Ausgang, dem Rückpfad und dem Masseknoten einzurichten.

**19.** Ein Verfahren zum Durchführen einer Zeitbereichsreflektometrie, das folgende Schritte umfasst:

Erzeugen eines Testsignals an einem Sender (5),

Liefern des Testsignals an ein Testtor (6) unter der Steuerung eines Multiplexers (4);

Verbinden jedes einer Mehrzahl von Ausgängen des Testtors (6) mit einem einer Mehrzahl von zu testenden Übertragungsmedien;

**dadurch gekennzeichnet, dass** das Verfahren folgende Schritte umfasst:

Bestimmen, Auswählen oder Bestätigen des Erdrückpfads für das ausgewählte Ausgangstor; und

Analysieren reflektierter Signale, die von dem zu testenden Übertragungsmedium und dem Erdrückpfad zurückempfangen werden, wodurch ermöglicht wird, dass Impedanzänderungen entlang der Länge der Übertragungsmedien und die jeweilige Entfernung zu den Impedanzänderungen für Übertragungsmedien mit bekannter und unbekannter Impedanz bestimmt werden.

**Revendications**

**1.** Réflectomètre temporel comprenant un émetteur (5) pour générer un signal de test, un multiplexeur (4) connecté à l'émetteur (5) et à un port de test (6), le port de test (6) comportant une pluralité de sorties, chacune d'entre elles pouvant être connectée à l'un d'une pluralité de supports de transmission devant être testés, le multiplexeur (4) pouvant être commandé pour causer l'acheminement de signaux provenant de l'émetteur (5) vers une sortie sélectionnée du port de test (6),

**caractérisé en ce que** l'on prévoit des moyens (2) pour déterminer, sélectionner ou confirmer le trajet de retour par la masse pour la sortie sélectionnée du port de test (6) et **en ce que** le réflectomètre comporte en outre des moyens pour analyser les signaux réfléchis reçus en retour des supports de transmission à tester et du trajet de retour par la masse en permettant de ce fait de déterminer des variations d'impédance sur la longueur du support de transmission à déterminer et la distance respective de ces variations d'impédance, pour des supports de transmission d'impédance connue et inconnue.

2. Réflectomètre temporel selon la revendication 1 , **caractérisé en ce que** le circuit (4, 5, 6) a une impédance fixe pour tous les supports à tester.

3. Réflectomètre temporel selon la revendication 2, **caractérisé en ce que** l'impédance fixe est une impédance de sortie comprise entre 75 et 130 ohms.

4. Réflectomètre temporel selon la revendication 3, **caractérisé en ce que** l'impédance de sortie fixe est environ égale à 100 ohms.

5. Réflectomètre temporel selon l'une quelconque des revendications précédentes, **caractérisé en ce que** les moyens pour analyser les signaux réfléchis permettent de déterminer l'impédance des supports de transmission connectés sur chaque sortie du port de test (6).

6. Réflectomètre temporel selon la revendication. 5, comprenant en outre des moyens pour déterminer, pour un support de transmission à tester, le support de transmission connecté à une autre sortie du port de test qui a l'impédance adaptée la plus proche pour l'utiliser comme trajet de retour par la masse.

7. Réflectomètre temporel selon l'une quelconque des revendications précédentes, comprenant en outre une pluralité de registres temporisés à décalage (140) qui sont commandés par des seuils qui, à leur tour, génèrent différentes cadences d'échantillonnage, chaque cadence d'échantillonnage fournissant une résolution en distance différente.

8. Réflectomètre temporel selon la revendication 7, **caractérisé en ce que** les moyens pour analyser les signaux réfléchis règlent plusieurs seuils qui déclenchent les registres temporisés à décalage (10).

9. Réflectomètre temporel selon l'une quelconque des revendications précédentes, **caractérisé en ce que** les moyens pour analyser comprennent un algorithme pour déterminer au début la localisation de la ou des impulsions réfléchies pour confirmer que la ou les impulsions représentent un défaut dans les supports de transmission.

10. Réflectomètre temporel selon l'une quelconque des revendications précédentes, **caractérisé en ce que** les moyens pour analyser comprennent un centre d'algorithme de masse pour déterminer de manière plus précise le niveau de la variation d'impédance.

11. Réflectomètre temporel selon l'une quelconque des revendications précédentes, **caractérisé en ce que** les moyens pour analyser comprennent un algorithme de corrélation croisée pour déterminer de manière plus précise la localisation de la ou ders impulsions.

12. Réflectomètre temporel selon l'une quelconque des revendications précédentes qui 'est conçu sous la forme d'un circuit intégré spécifique ASIC entièrement intégré.

13. Réflectomètre temporel selon l'une quelconque des revendications précédentes qui peut être utilisé avec un support de transmission sur lequel on transmet également de la puissance en courant alternatif ou en courant alternatif au moment même ou on est en train de réaliser le test.

14. Réflectomètre temporel selon l'une quelconque des revendications précédentes comprenant en outre des moyens pour fournir une cartographie des impédances d'un câble isolé ou d'un faisceau en cours de test.

15. Réflectomètre temporel selon l'une quelconque des revendications précédentes comprenant en outre un circuit de réception qui est connecté au multiplexeur (4), le multiplexeur (4) pouvant être commandé pour acheminer des signaux réféchis provenant de la sortie sélectionnée du circuit de réception, et dans lequel le circuit de réception est connecté à un circuit échantillonneur-bloqueur (8, 130) destiné à échantillonner les signaux reçus.

**16.** Réflectomètre temporel selon la revendication 15, comprenant en outre un dispositif de commande (2) qui est configuré pour commander le multiplexeur (4) pour déterminer et établir des trajets d'acheminement du signal allant de l'émetteur (5) vers la sortie sélectionnée, dans lequel le dispositif de commande (2) est configuré pour accepter une entrée sélectionnant la sortie à tester, pour commander le multiplexeur (4) pour établir un trajet d'acheminement du signal allant de l'émetteur (5) à la sortie sélectionnée, déterminer et établir un trajet d'acheminement du signal en retour allant de la sortie sélectionnée vers le circuit de réception.

**17.** Réflectomètre temporel selon la revendication 16, comportant en outre un noeud de masse (GRND) qui est connecté au multiplexeur (4), dans lequel le multiplexeur (4) peut être commandé pour acheminer des signaux provenant des supports de transmission vers le noeud de masse.

**18.** Réflectomètre temporel selon la revendication 16, dans lequel le dispositif de commande (2) est configuré pour commuter sur chaque sortie pour déterminer l'impédance la plus proche de la sortie sélectionnée et pour établir le trajet de retour et, de ce fait, le trajet d'acheminement du signal entre la sortie, le trajet de retour et le noeud de masse.

**19.** Procédé pour réaliser une réflectométrie temporelle comprenant les étapes suivantes :

générer un signal de test dans un émetteur (5),
fournir le signal de test à un port de test (6) sous la commande d'un multiplexeur (4),
connecter chacune d'une pluralité de sortie du port de test (6) à l'une d'une pluralité de supports de transmission devant être testés ;

**caractérisé en ce que** le procédé comprend les étapes suivantes :

déterminer, sélectionner ou confirmer le trajet de retour par la masse pour la sortie du port sélectionnée ; et analyser les signaux réfléchis reçus en retour des supports de transmission à tester et du trajet de retour par la masse en permettant de ce fait de déterminer des variations d'impédance sur la longueur du support de transmission à déterminer et la distance respective de ces variations d'impédance, pour des supports de transmission d'impédance connue et inconnue.

FIG. 1

Fig. 2

Fig. 3

Fig. 4

Fig. 5

Fig. 6

FIG. 7